# EUROPEAN PATENT APPLICATION

(11) **EP 4 425 579 A1**
(43) Date of publication of application: **04.09.2024**
(21) Application number: 24158762.5
(22) Date of filing: 21.02.2024
(51) Int. Cl.: H01L 31/05, H01L 31/18, H01L 31/048

(54) **METHOD OF MANUFACTURING SOLAR CELL STRING**

(30) Priority: 28.02.2023 JP 2023029929
(71) Applicant: Panasonic Holdings Corporation, Osaka 571-8501 (JP)
(72) Inventor: IRIKAWA, Junpei, Kadoma-shi, Osaka, 571-0057 (JP); HASHIMOTO, Haruhisa, Kadoma-shi, Osaka, 571-0057 (JP)
(74) Representative: Müller-Boré & Partner Patentanwälte PartG mbB

(57) **Abstract**

A method of manufacturing a solar cell string according to an embodiment of the present disclosure includes a provisional fixation step in which, at a first position and at a temperature lower than or equal to 50°C, a wiring member (21) is placed over a solar cell (20) with an adhesive (22) therebetween, and the wiring member (21) and the solar cell (20) are provisionally fixed to each other, a transport step in which, after the provisional fixation step, the wiring member (21) and the solar cell (20) are moved to a second position while a state in which the wiring member (21) and the solar cell (20) are provisionally fixed to each other by stickiness of the adhesive (22) is maintained, and a pressure-bonding step in which, at the second position, the adhesive (22) is heated to a temperature greater than or equal to a curing temperature of the adhesive (22) while the wiring member (21) is pressurized, to cure the adhesive (22). A viscosity of the adhesive (22) before being cured, at a temperature of 30°C and a shearing velocity of 0.01/sec., is greater than or equal to 50 Pa·s.

## Description

### TECHNICAL FIELD

The present disclosure relates to a method of manufacturing a solar cell string.

### BACKGROUND

In the related art, a solar cell module is known which includes a solar cell string in which a plurality of solar cells are electrically connected to each other by a wiring member (refer to JP 5367569 B). In general, solder junction is used for connection between the solar cell and the wiring member, but in some cases, an adhesive formed from a thermosetting resin is used from the viewpoints of reduction of temperature of processes and improved reliability of the solar cell module. In this case, the solar cell string is manufactured by, in a state where the wiring member is placed over an electrode of the solar cell with the adhesive therebetween, heating the solar cell and the wiring member to a temperature greater than or equal to a curing temperature of the adhesive, to cure the adhesive.

In the process, if the solar cell and the wiring member are not accurately handled after the wiring member is placed over the electrode of the solar cell and before the adhesive is cured, misalignment of the wiring member may be caused. When the misalignment of the wiring member occurs, there is a possibility that short-circuiting between the electrodes may occur, connection deficiency between the electrode and the wiring member may occur, and reliability may be reduced.

JP 5367569 B discloses a method of manufacturing a solar cell string in which, after the wiring member is placed over the electrode of the solar cell with a resin adhesive therebetween, the structure is heated to a temperature lower than the curing temperature of the resin adhesive, so as to provisionally adhere the electrode and the wiring member to each other. With the provisional adhesion of the electrode and the wiring member, the misalignment of the wiring member until the adhesive is cured can be suppressed.

In the method of manufacturing the solar cell string, such as that disclosed in JP 5367569 B, in which the solar cell and the wiring member are heated to a temperature lower than the curing temperature of the resin adhesive, to provisionally adhere the wiring member over the electrode of the solar cell, the adhesive adhered to a manufacturing apparatus of the solar cell string may solidify due to the heating, resulting in contamination of the manufacturing apparatus. In such an event, the operation of the manufacturing apparatus must be stopped in order to clean the manufacturing apparatus, and there is a problem in that productivity may be easily reduced.

### SUMMARY

According to one aspect of the present disclosure, there is provided a method of manufacturing a solar cell string including: solar cells including a first solar cell having a first surface and a second surface which face in opposite directions to each other, and a second solar cell having a first surface and a second surface which face in opposite directions to each other, and placed adjacent to the first solar cell; and a wiring member connecting the first surface of the first solar cell and the second surface of the second solar cell, the method including: a provisional fixation step in which, at a first position and at a temperature lower than or equal to 50°C, the wiring member is placed over the solar cell with an adhesive therebetween, and the wiring member and the solar cell are provisionally fixed to each other; a transport step in which, after the provisional fixation step, the wiring member and the solar cell are moved to a second position while maintaining a state where the wiring member and the solar cell are provisionally fixed to each other by stickiness of the adhesive; and a pressure-bonding step in which, at the second position, the adhesive is heated to a temperature greater than or equal to a curing temperature of the adhesive while the wiring member is pressurized, to cure the adhesive. A viscosity of the adhesive before being cured at a temperature of 30°C and a shearing velocity of 0.01/sec. is greater than or equal to 50 Pa s.

According to an aspect of the present disclosure, a method of manufacturing a solar cell string with improved productivity can be provided.

### BRIEF DESCRIPTION OF DRAWINGS

The figures depict one or more implementations in accordance with the present teachings, by way of example only, not by way of limitations. In the figures, like reference numerals refer to the same or similar elements. Embodiments of the present disclosure will be described based on the following figures, wherein:
FIG. 1 is a cross-sectional diagram of a solar cell module according to an embodiment of the present disclosure.
FIG. 2 is a plan view of the solar cell according to the embodiment of the present disclosure, viewed from a first surface side.
FIG. 3 is a flowchart showing a method of manufacturing the solar cell string according to the embodiment of the present disclosure.
FIG. 4A is a diagram showing a provisional fixation step of the method of manufacturing the solar cell string according to the embodiment of the present disclosure.
FIG. 4B is a diagram showing the provisional fixation step of the method of manufacturing the solar cell string according to the embodiment of the present disclosure.
FIG. 4C is a diagram showing the provisional fixation step of the method of manufacturing the solar cell string according to the embodiment of the present disclosure.
FIG. 4D is a diagram showing the provisional fixation step of the method of manufacturing the solar cell string according to the embodiment of the present disclosure.
FIG. 4E is a diagram showing the provisional fixation step of the method of manufacturing the solar cell string according to the embodiment of the present disclosure.
FIG. 4F is a diagram showing the provisional fixation step of the method of manufacturing the solar cell string according to the embodiment of the present disclosure.
FIG. 5 is a diagram showing the provisional fixation step of the method of manufacturing the solar cell string according to the embodiment of the present disclosure.
FIG. 6 is a diagram showing the provisional fixation step of the method of manufacturing the solar cell string according to the embodiment of the present disclosure.
FIG. 7 is a diagram showing a pressure-bonding step of the method of manufacturing the solar cell string according to the embodiment of the present disclosure.
FIG. 8 is a perspective diagram schematically showing a pressure-bonding apparatus used in the pressure-bonding step of the method of manufacturing the solar cell string according to the embodiment of the present disclosure.
FIG. 9A is a diagram showing a provisional fixation step of a method of manufacturing a solar cell string according to another configuration of the embodiment of the present disclosure.
FIG. 9B is a diagram showing the provisional fixation step of the method of manufacturing the solar cell string according to the other configuration of the embodiment of the present disclosure.
FIG. 9C is a diagram showing the provisional fixation step of the method of manufacturing the solar cell string according to the other configuration of the embodiment of the present disclosure.
FIG. 10A is a diagram showing a provisional fixation step of a method of manufacturing a solar cell string according to yet another configuration of the embodiment of the present disclosure.
FIG. 10B is a diagram showing the provisional fixation step of the method of manufacturing the solar cell string according to the other configuration of the embodiment of the present disclosure.
FIG. 10C is a diagram showing the provisional fixation step of the method of manufacturing the solar cell string according to the other configuration of the embodiment of the present disclosure.

### DESCRIPTION OF EMBODIMENTS

A solar cell module according to an embodiment of the present disclosure will now be described in detail with reference to the drawings. The drawings referred to in the embodiment are schematically described, and a size ratio of constituting elements drawn in the figures or the like should be determined in consideration of the following description.

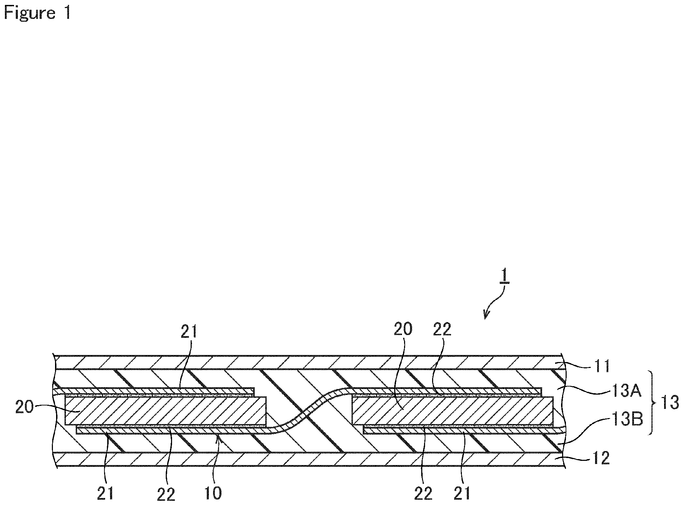

With reference to FIG. 1, a structure of a solar cell module 1 according to a first embodiment of the present disclosure will be described. FIG. 1 is a cross-sectional diagram of the solar cell module 1 according to the first embodiment.

As shown in FIG. 1, the solar cell module 1 includes a solar cell string 10 including a plurality of solar cells 20, a first protective member 11, and a second protective member 12. The first protective member 11 is provided on a side of a first surface of the solar cell string 10, and the second protective member 12 is provided on a side of a second surface of the solar cell string 10. In the present embodiment, the first surface serves as a light receiving surface, and the second surface serves as a back surface. The first protective member 11 is a member that protects the side of the first surface of the cell, and the second protective member 12 is a member that protects the side of the second surface of the cell. In addition, the solar cell module 1 includes a sealing layer 13 which is provided between the first protective member 11 and the second protective layer 12, and which seals the solar cell string 10.

The "light receiving surface" of the solar cell string 10 means a surface on which the light is primarily incident, and the "back surface" means a surface on an opposite side to the light receiving surface. Of the light incident on the solar cell string 10, more than 50% of the light, for example, greater than or equal to 80% or greater than or equal to 90% of the light, is incident from the light receiving surface side.

As will be described later in detail, the solar cell string 10 includes a plurality of solar cells 20, a wiring member 21, and an adhesive 22. The solar cell string 10 is formed by connecting a plurality of solar cells 20, arranged along a direction of arrangement, to each other by the wiring member 21.

For the first protective member 11, for example, a glass substrate, a resin substrate, or the like which has a light transmissive property is employed. The first protective member 11 is in general flat, but may alternatively be curved. For the second protective member 12, a transparent member identical to the member for the first protective member 11 may be employed, or a non-transparent member may be employed. For the second protective member 12, for example, a resin sheet having a thinner thickness than the first protective member 11 may be employed.

The resin substrate applied as the first protective member 11 and the second protective member 12 is formed from, for example, at least one material selected from polyethylene (PE), polypropylene (PP), cyclic polyolefin, polycarbonate (PC), polymethylmethacrylate (PMMA), polytetrafluoroethylene (PTFE), polystyrene (PS), polyethylene terephthalate (PET), polyethylene naphthalate (PEN), polyvinyl fluoride (PVF), and polyvinylidene fluoride (PVDF).

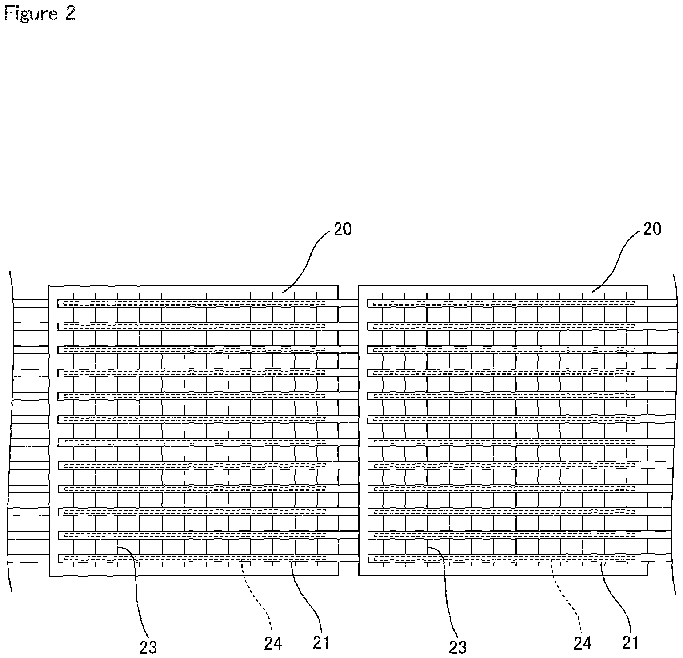

The sealing layer 13 is a resin layer which is provided between the first protective member 11 and the second protective layer 12, and which seals each solar cell 20. The sealing layer 13 closely contacts the solar cell 20 to restrict movement of the cell, and seals the solar cell 20 so that the solar cell 20 is not exposed to oxygen, water vapor, or the like. In the configuration exemplified in FIG. 2, the sealing layer 13 directly contacts each of the protective members and each of the solar cells 20. The solar cell module 1 has a layered structure in which the first protective member 11, the sealing layer 13, the solar cell string 10, the sealing layer 13, and the second protective member 12 are layered in this order from the side of the first surface. In the present embodiment, all of the solar cells 20 are sealed by the sealing layer 13, but alternatively, a structure may be employed in which, for example, a part of at least one solar cell 20 extends beyond the sealing layer 13. The sealing layer 13 is formed from a resin material such as, for example, polyolefin such as polyethylene or polypropylene, a copolymer of ethylene vinyl acetate (EVA), polyvinyl butyral (PVB), polyimide, polyethylene terephthalate (PET), or the like.

The sealing layer 13 is formed from a first sealing layer 13A provided between the first protective member 11 and the solar cell 20, and a second sealing layer 13B provided between the second protective member 12 and the solar cell 20. The sealing layer 13 is desirably formed through a laminating process that will be described layer, using a resin member forming the first sealing layer 13A, and a resin member forming the second sealing layer 13B. For the first sealing layer 13A and the second sealing layer 13B, the same resin member may be employed, or different resin members may be employed. When the compositions of the resin members are the same, it may not be possible to recognize the interface between the sealing layers.

Next, with further reference to FIG. 2, the structure of the solar cell string 10 according to the present embodiment will be described. FIG. 2 is a plan view of the solar cell 20 forming the solar cell string 10 of FIG. 1, viewed from the side of the first surface.

As described above, the solar cell string 10 includes the plurality of solar cells 20, the wiring member 21, and the adhesive 22. The solar cell string 10 is formed by connecting the plurality of solar cells 20, arranged along the direction of arrangement, to each other by the wiring member 21.

The solar cell 20 includes a photovoltaic unit which generates carriers by receiving solar light, and a current collector electrode which is provided over the photovoltaic unit and which collects the carriers.

An example of the photovoltaic unit is a structure including a semiconductor substrate such as crystalline silicon (Si), gallium arsenide (GaAs), indium phosphide (InP), and the like, an amorphous semiconductor layer formed over the semiconductor substrate, and a transparent conductive layer formed over the amorphous semiconductor layer. More specifically, a structure may be exemplified in which an i-type amorphous silicon layer, a p-type amorphous silicon layer, and a transparent conductive layer are formed in this order over one surface of an n-type monocrystalline silicon substrate, and an i-type amorphous silicon layer, an n-type amorphous silicon layer, and a transparent conductive layer are formed in this order over the other surface of the substrate.

The current collector electrode is formed from a first surface electrode (light receiving surface electrode) formed over a first surface of the photovoltaic unit, and a second surface electrode (back surface electrode) formed over a second surface of the photovoltaic unit. In this case, one of the first surface electrode and the second surface electrode serves as an n-side electrode, and the other serves as a p-side electrode.

As shown in FIG. 2, the current collector electrode desirably includes a plurality of finger electrodes 23. However, for the second surface electrode, an electrode may be employed which covers approximately the entire region of the second surface of the photovoltaic unit. The plurality of finger electrodes 23 are electrodes of narrow line shape, formed approximately parallel with each other.

The current collector electrode may include a bus bar electrode 24 having a wider width than the finger electrode 23 and which is approximately orthogonal to each finger electrode. The wiring member 21 is attached to the bus bar electrode 24. The current collector electrode has a structure in which, for example, a conductive filler such as silver (Ag) is dispersed in a binder resin. The current collector electrode having this structure may be formed, for example, through screen printing. The structure of the photovoltaic unit may be, as an alternative to the hetero-junction type structure described above, TOPCON-type (Tunnel Oxide Passivated Contact cell) or PERC-type (Passivated Emitter and Rear Cell), and the polarity of the substrate and the first surface is not limited to the n type. The current collector electrode may be formed, as an alternative to Ag, from metal having aluminum (Al), copper (Cu), or the like as a primary composition.

The wiring member 21 is, for example, a line member having a cross section in a radial direction of an approximate true circle shape, and is formed with metal such as Al and Cu as a primary composition. The wiring member 21 may include a plating layer having, as a primary composition, Ag, nickel (Ni), or a low melting point metal used as solder. For example, a diameter of the wiring member 21 is, for example, greater than or equal to 0.2 mm and less than or equal to 0.4 mm. Desirably, a plurality of the wiring members 21 are attached to the first surface and the second surface of the solar cell 20. In the present embodiment, 12 wiring members 21 are provided, but the number of the wiring members 21 is not limited to this number, and may be less than 12 or greater than or equal to 13. Further, the cross-sectional shape of the wiring member 21 is not limited to the approximate true circle shape, and may alternatively be an approximate rectangular shape. When the cross-sectional shape of the wiring member 21 is the approximate rectangular shape, a thickness of the wiring member 21 is, for example, greater than or equal to 0.2 mm and less than or equal to 0.3 mm, and a width of the wiring member 21 is, for example, greater than or equal to 0.6 mm and less than or equal to 2.0 mm.

The wiring member 21 is placed along a longitudinal direction of the solar cell string 10, and is provided from a one-side end of one solar cell 20 among adjacent solar cells 20 to the other-side end of the other solar cell 20. A length of the wiring member 21 is slightly shorter than a length obtained by adding the lengths of two solar cells 20 and an inter-cell distance. The wiring members 21 are bent in a thickness direction of the module between adjacent solar cells 20, and are joined to the first surface of the one solar cell 20 and the second surface of the other solar cell 20, respectively, using the adhesive 22 that will be described below. The wiring member 21 is electrically connected to the current collector electrodes of the solar cells 20. In FIG. 2, a case is illustrated in which 12 wiring members 21 are connected to 12 bus bar electrode 24.

The adhesive 22 is placed between the solar cell 20 and the wiring member 21. In other words, the wiring member 21 is joined to the solar cell 20 via the adhesive 22. The adhesive 22 is desirably a thermosetting adhesive. As the thermosetting adhesive, there may be exemplified, for example, a urea-based adhesive, a resorcinol-based adhesive, a melamine-based adhesive, a phenol-based adhesive, an epoxy-based adhesive, a polyurethane-based adhesive, a polyester-based adhesive, a polyimide-based adhesive, and an acryl-based adhesive.

A curing temperature of the adhesive 22 is desirably lower than or equal to 220°C, and is more desirably lower than or equal to 200°C. The adhesive 22 before being cured is in a liquid form. Here, the "liquid form" refers to a state having fluidity at 30°C, and is intended to include a state called a paste form.

A viscosity of the adhesive 22 before being cured is greater than or equal to 50 Pa·s, is desirably greater than or equal to 75 Pa s, is more desirably greater than or equal to 100 Pa·s, and is further desirably greater than or equal to 125 Pa s. In this case, the wiring member 21 can be easily provisionally fixed over the solar cell 20 in the provisional fixation step that will be described later. The above-described viscosity is based on the standard, JIS K7117-2:1999, "Plastic -liquid, emulsion, or dispersive resin- measurement method for viscosity at constant shearing velocity by rotating circular clock", and is a value measured under conditions of a temperature of 30°C and a shearing velocity of 0.01/sec., and using a cone-plate rotating viscometer (having a jig radius of 24 mm and an angle of 1.34) (TV25 viscometer manufactured by Toki-Sangyo).

The adhesive 22 may contain a conductive filler such as Ag particles, but from the viewpoints of reduction of the manufacturing cost and reduction of light shielding loss, the use of non-conductive thermosetting adhesive which does not contain the conductive filler is desirable. When the non-conductive adhesive 22 is used, one or both of the wiring member 21 or the current collector electrode of the solar cell 20 is/are made uneven, and the insulative adhesive 22 is removed from the region between the wiring member 21 and the current collector electrode of the solar cell 20, so that the solar cell 20 and the wiring member 21 can be electrically connected to each other.

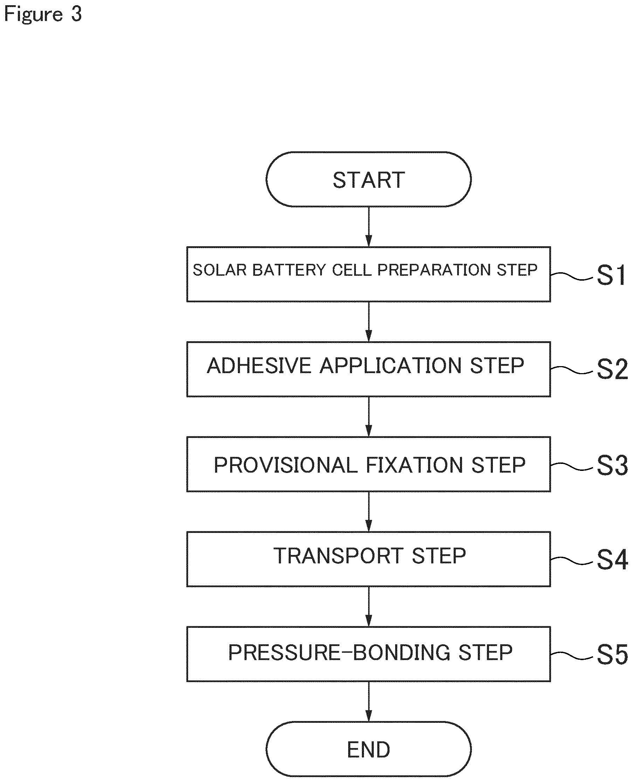

Next, a method of manufacturing the solar cell string 10 according to the present embodiment will be described with reference to FIGs. 3 to 7. FIG. 3 is a flowchart showing the method of manufacturing the solar cell string 10 according to the present embodiment.

As shown in FIG. 3, the manufacturing method according to the present embodiment includes a solar cell preparation step S1, an adhesive application step S2, a provisional fixation step S3, a transport step S4, and a pressure-bonding step S5.

The solar cell preparation step S1 is a step in which a plurality of solar cells 20 forming the solar cell string 10 are prepared. The adhesive application step S2 is a step in which the adhesive 22 (refer to FIG. 1) is applied over the first surface and the second surface of the solar cell 20 along an arrangement position of the wiring member 21.

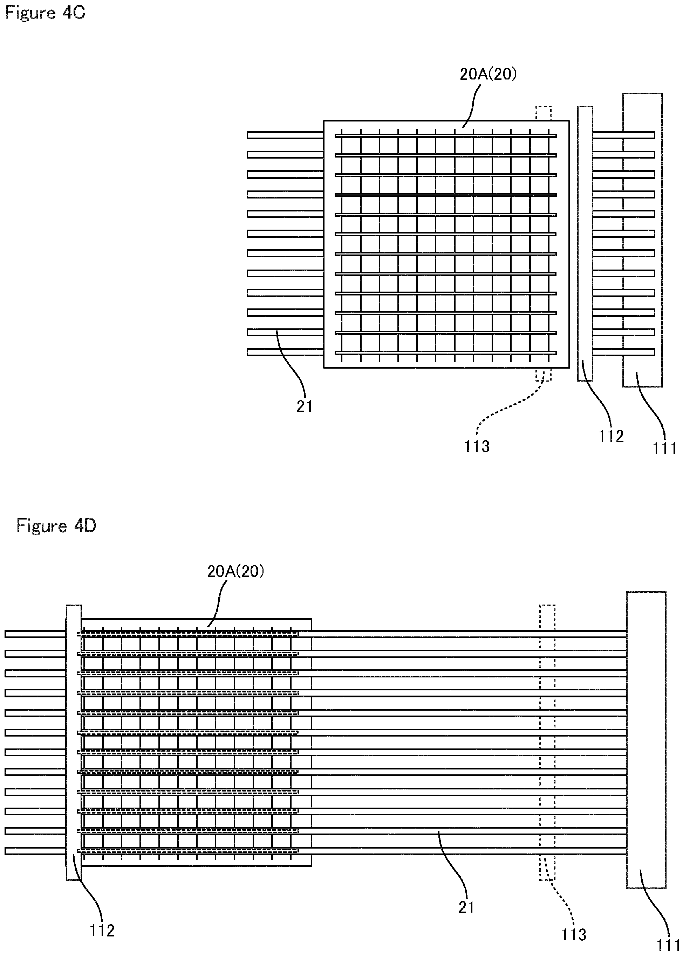

In the adhesive application step S2, the adhesive 22 may be applied alternately over the first surface and the second surface of the solar cell 20, or may be applied simultaneously over the first surface and the second surface. Further, patterns of the adhesive 22 applied over the first surface and the second surface of the solar cell 20 may be the same pattern for the first surface and the second surface, or may be different patterns. As the application method, screen printing, dispensing, or die-coating may be employed, or, alternatively, other methods may be employed. When the adhesive 22 is to be applied alternately over the first surface and the second surface, a table may be used which is inverted after application over one surface, and over which a groove is formed at a location corresponding to a portion to be printed. In addition, an amount of the adhesive 22 applied to a region which contacts a wiring member drawer 112 (refer to FIG. 4D) in the provisional fixation step S3 to be described later may be smaller than an amount of the adhesive 22 applied to other regions. With this configuration, it is possible to suppress contamination of the wiring member drawer 112 by the adhesive 22.

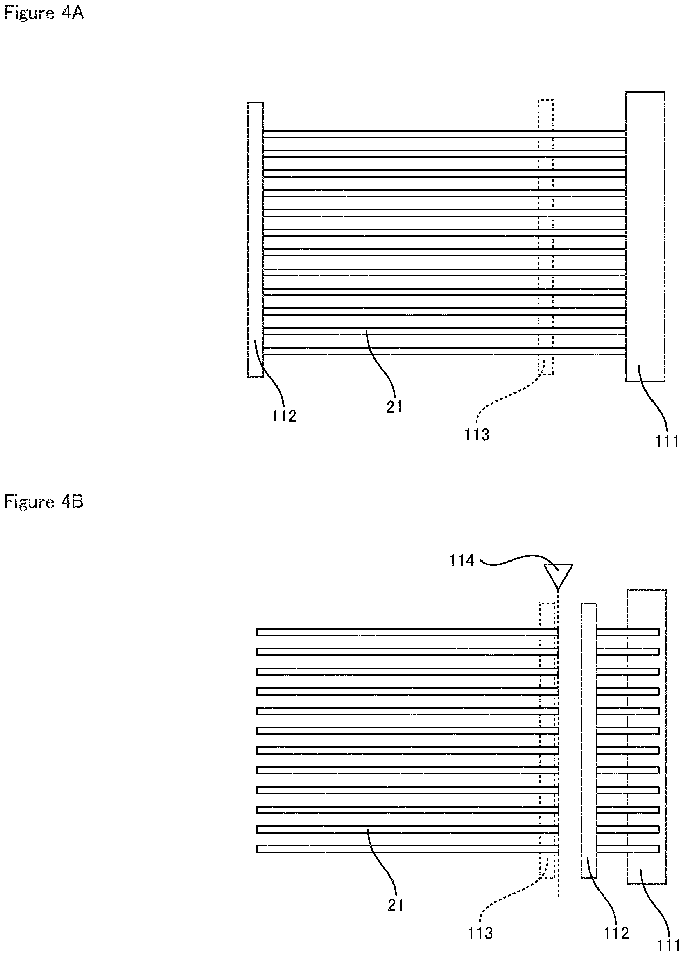

Next, the provisional fixation step S3 will be described in detail with reference to FIGs. 4A to 4F. FIGs. 4A to 4F are diagrams showing the provisional fixation step S3, and are plan views of the solar cell 20 viewed from the side of the first surface. The provisional fixation step S3 is a step in which the wiring member 21 is provisionally fixed over the first surface and the second surface of the solar cell 20 with the adhesive 22 (refer to FIG. 1) therebetween. In the present disclosure, the "provisional fixation" refers to a state in which the solar cell 20 and the wiring member 21 contact each other with the adhesive 22 therebetween, and are fixed to each other with the adhesive 22 therebetween, by stickiness of the adhesive 22, and to a degree to allow separation from each other, and in which the heating process is not yet performed.

First, as shown in FIG. 4A, a predetermined length of the wiring member 21 is drawn out from a wiring member winding portion 111, in which the wiring member 21 is wound around a bobbin or the like, by the wiring member drawer 112. In this process, the wiring member drawer 112 applies a tension force in the length direction of the wiring member 21 to the wiring member 21, so that the curvature of the wiring member 21 can be straightened, and a straightness of the wiring member 21 can be improved. Next, the wiring member 21 drawn out by the wiring member drawer 112 is placed over a stage (not shown) having a transporting function, and is fixed on the stage by a wiring member fixer 113.

No particular limitation is imposed on a structure of the wiring member fixer 113 so long as the wiring member fixer 113 can fix the wiring member 21 on the stage. The wiring member fixer 113 may be, for example, a suction hole which is provided on the stage and which sucks outside air.

Next, as shown in FIG. 4B, the wiring member drawer 112 is separated from the wiring member 21, and is moved to a predetermined position, and the wiring member 21 is held. Then, the wiring member 21 is cut into a predetermined length by a wiring member cutter 114. With this process, the wiring member 21 having the predetermined length is placed on the stage in a fixed state.

Next, as shown in FIG. 4C, a solar cell 20A is placed over the wiring member 21 fixed on the stage. In this process, the solar cell 20A is placed such that the adhesive 22 applied over the second surface of the solar cell 20A overlaps the wiring member 21 fixed on the stage. With this process, the current collector electrode formed over the second surface of the solar cell 20A, and the wiring member 21, are provisionally fixed to each other with the adhesive 22 therebetween.

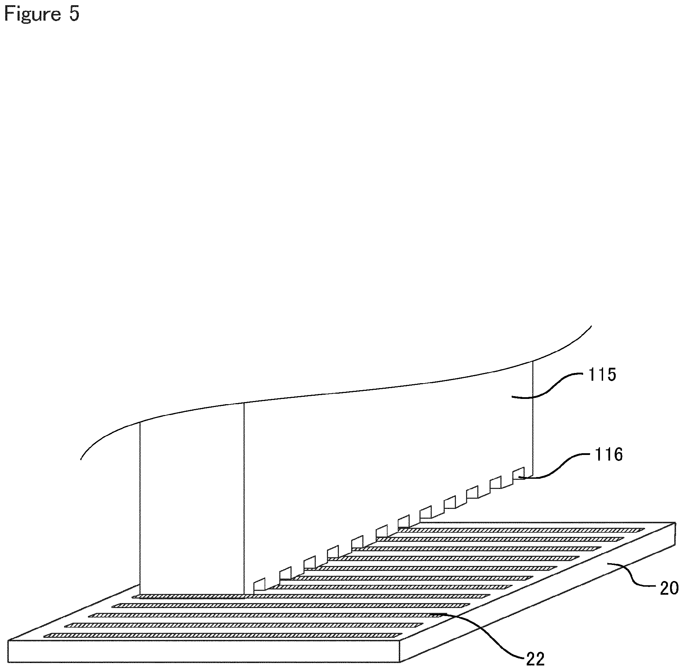

When the solar cell 20A is placed over the wiring member 21, the solar cell 20A may be pressurized with a pressing mechanism 115 (refer to FIG. 5) from the side of the first surface of the solar cell 20A, to press the second surface of the solar cell 20A against the wiring member 21. In this process, in order to prevent attachment of the adhesive 22, applied over the first surface of the solar cell 20A, to the pressing mechanism 115, a groove 116 may be formed over a surface of the pressing mechanism 115 which contacts the first surface of the solar cell 20A, at a position opposing the adhesive 22 during the pressing. As shown in FIG. 5, in the present embodiment, the groove 116 having a uniform width along the length direction of the wiring member 21 is formed on the surface of the pressing mechanism 115 which contacts the solar cell 20A. With this configuration, attachment of the adhesive 22, applied over the first surface of the solar cell 20A, to the pressing mechanism 115 can be suppressed, and the wiring member 21 can be more firmly provisionally fixed to the second surface of the solar cell 20A. As a result, misalignment and dropping-off of the wiring member 21 can be suppressed. Desirably, a hardness of the portion of the pressing mechanism 115 which contacts the solar cell 20A is lower than or equal to D40. The hardness described above is a value measured using a type-D durometer, according to a method described in the standard, JIS K6254-3:2012.

Next, as shown in FIG. 4D, the solar cell 20A is moved to the left of FIG. 4D by a distance corresponding to one cell, and then, a predetermined length of the wiring member 21 is drawn out from the wiring member winding portion 111 by the wiring member drawer 112, and the winding member drawer 112 is moved to a predetermined position. The wiring member 21 is fixed on the stage by the wiring member fixer 113, and then, the wiring member 21 is pressed against the side of the first surface of the solar cell 20A. In this process, for pressing the wiring member 21 against the solar cell 20A, the wiring member drawer 112 may be used, or a mechanism may be used in which a position of a tip of the pressing mechanism 115, which is used in the pressing of the second surface of the solar cell 20A and the wiring member 21 against each other, and which has the tip with a hardness of greater than or equal to D40, is matched with a position of the wiring member 21, or a flat-plate shape mechanism may be used. With this process, the current collector electrode formed over the first surface of the solar cell 20A and the wiring member 21 are provisionally fixed to each other with the adhesive 22 therebetween.

A pressure when the wiring member 21 is pressed against the first surface of the solar cell 20A is desirably greater than or equal to 10 Pa. In this case, the wiring member 21 is more firmly provisionally fixed to the first surface of the solar cell 20A, and the misalignment and dropping-off of the wiring member 21 can be suppressed. Further, when the wiring member 21 is pressed against the first surface of the solar cell 20A, the wiring member drawer 112 may press the side of the first surface of the solar cell 20A while applying a tension force to the wiring member 21 in the length direction of the wiring member 21. With this process, the curvature of the wiring member 21 can be further straightened, and the straightness of the wiring member 21 can be further improved. After the wiring member 21 is provisionally fixed to the first surface of the solar cell 20A, the wiring member 21 is separated from the wiring member drawer 112.

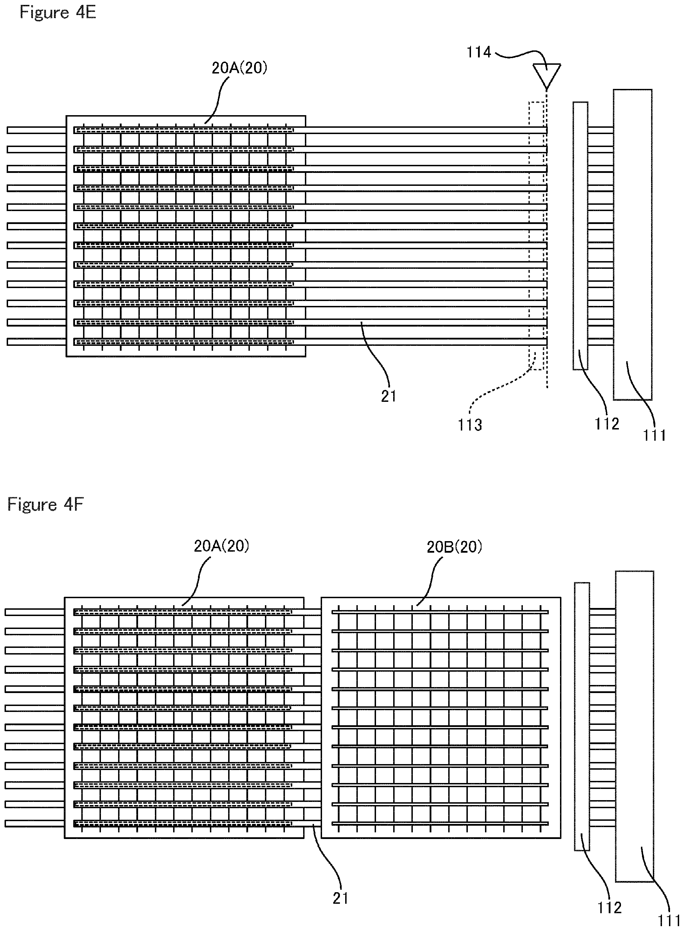

Next, as shown in FIG. 4E, the wiring member drawer 112 is separated from the wiring member 21, and is moved to a predetermined position, and the wiring member 21 is held. Then, the wiring member 21 is cut into a predetermined length by the wiring member cutter 114.

Then, as shown in FIG. 4F, another solar cell 20B is placed in a region, of the wiring member 21 fixed on the stage, where the wiring member 21 is not provisionally fixed with the solar cell 20A. In this process, the solar cell 20B is placed such that the adhesive 22 applied over the second surface of the solar cell 20B overlaps the wiring member 21 fixed on the stage. With this process, the current collector electrode formed over the second surface of the solar cell 20B and the wiring member 21 are provisionally fixed to each other with the adhesive 22 therebetween.

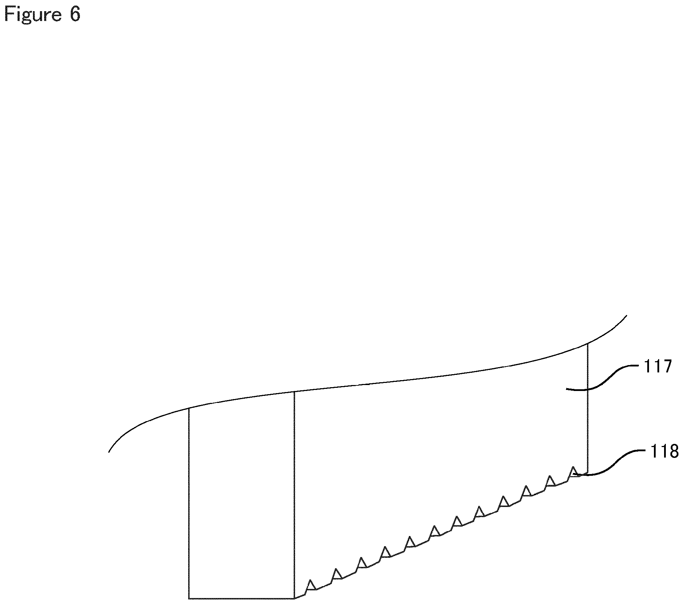

Alternatively, the position of the wiring member 21 may be adjusted before and after the placement of the solar cell 20B over the wiring member 21. As a method of adjusting the position of the wiring member 21, for example, a method as shown in FIG. 6 may be employed in which a position adjusting mechanism 117 is prepared having a cutout 118 formed at an appropriate position corresponding to the wiring member 21, and having a member with a surface made of a resin, and the position adjusting mechanism 117 is slid in the length direction of the wiring member 21. With this process, the wiring member 21 on the stage is guided to the appropriate position.

When the stage is moved to the left of FIG. 4D after the current collector electrode formed over the second surface of the solar cell 20B and the wiring member 21 are provisionally fixed to each other, so that the solar cell 20B is moved to the position of the solar cell 20A before the movement, the position of the wiring member 21 may be adjusted in correspondence with the movement of the stage.

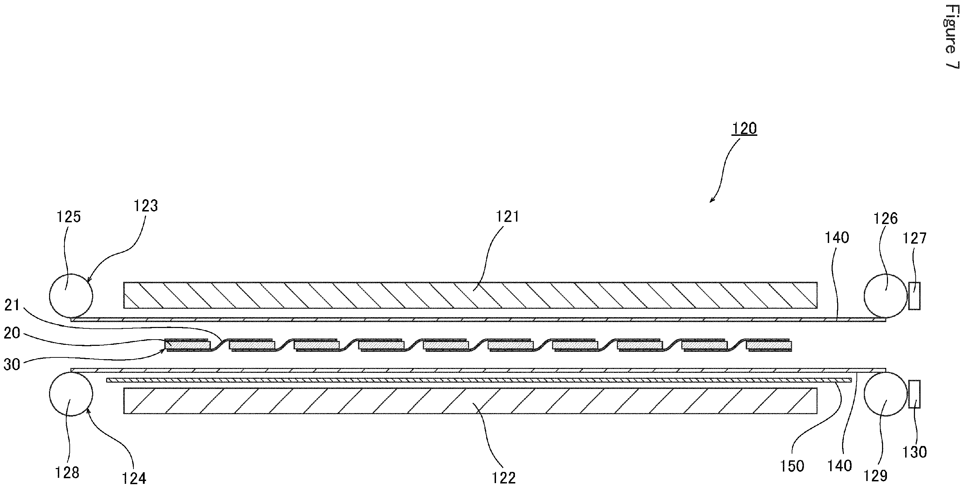

The steps described above and shown in FIGs. 4D to 4F are repeated a predetermined number of times, so that a provisionally fixed assembly 30 (refer to FIG. 7) can be produced in which a plurality of the solar cells 20 are provisionally fixed. In addition, as described above, in the provisional fixation step S3, the solar cell 20, the wiring member 21, and the adhesive 22 are not heated, and are processed at a temperature lower than or equal to 50°C, desirably, a temperature lower than or equal to 30°C. With this configuration, scattering of the resin or the like forming the adhesive 22 does not occur, and contamination of the manufacturing apparatus of the solar cell string 10 can be suppressed. In addition, even when the adhesive 22 is attached to the manufacturing apparatus due to operation defect or the like, because the heating process is not applied, the adhesive 22 does not solidify on the manufacturing apparatus, and can be easily wiped away.

The transport step S4 is a step in which the provisionally fixed assembly 30 produced in the provisional fixation step S3 is transported to a pressure-bonding apparatus 120 (refer to FIG. 7) used in the pressure-bonding step S5. In the present embodiment, the provisionally fixed assembly 30 is transported using a conveyer apparatus. In addition, in the transport step S4, the provisionally fixed assembly 30 is not pressurized or heated, and is transported at a temperature lower than or equal to 50°C, desirably, a temperature lower than or equal to 30°C. With this configuration, similar to the provisional fixation step S3, scattering of the resin or the like forming the adhesive 22 does not occur, and the contamination of the manufacturing apparatus of the solar cell string 10 can be suppressed. In addition, even when the adhesive 22 is attached to the manufacturing apparatus, because the heating process is not applied, the adhesive 22 does not solidify on the manufacturing apparatus, and can be easily wiped away. In the transport step S4, desirably, the provisionally fixed assembly 30 is transported in the length direction of the wiring member 21. With this configuration, the misalignment and the dropping-off of the wiring member 21 can be suppressed.

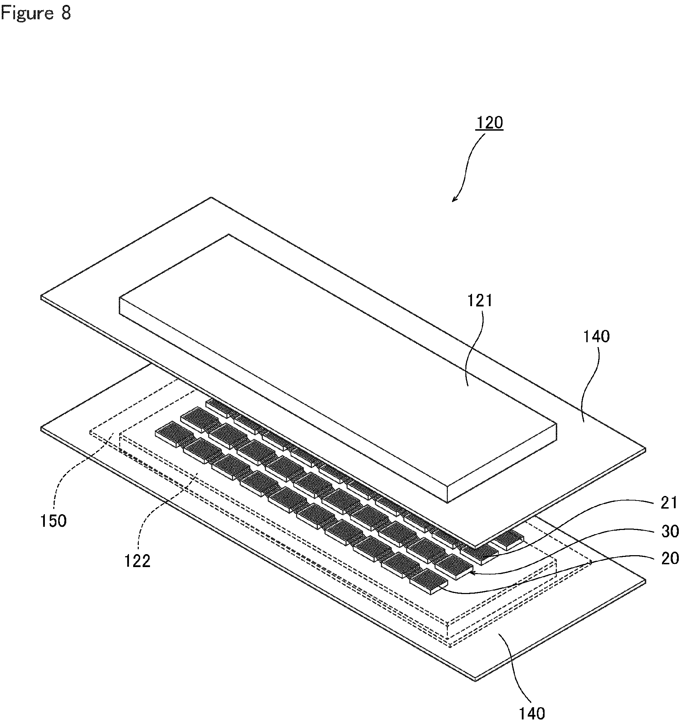

The pressure-bonding step S5 will now be described in detail with reference to FIGs. 7 and 8. FIG. 7 is a side view schematically showing the pressure-bonding apparatus 120 used in the pressure-bonding step S5, and FIG. 8 is a perspective diagram schematically showing the pressure-bonding apparatus 120. The pressure-bonding step S5 is a step in which the adhesive 22 (refer to FIG. 1) of the provisionally fixed assembly 30 is completely cured, to thereby adhere the current collector electrode of the solar cell 20 and the wiring member 21, and to consequently manufacture the solar cell string 10. In the pressure-bonding step S5, a plurality of provisionally fixed assemblies 30 may be simultaneously pressure-bonded, in which case, a plurality of cell strings are transported in parallel in the transport step S4. FIG. 8 shows a case in which four provisionally fixed assemblies 30 are simultaneously pressure-bonded.

As shown in FIGs. 7 and 8, the pressure-bonding apparatus 120 used in the pressure-bonding step S5 includes an upper pressurizing member 121 provided on the side of the first surface of the solar cell 20, and a lower pressurizing member 122 provided on the side of the second surface of the solar cell 20. The pressure-bonding apparatus 120 further includes an upper sheet placement mechanism 123 provided on the side of the first surface of the solar cell 20, and a lower sheet placement mechanism 124 provided on the side of the second surface of the solar cell 20. In FIGs. 7 and 8, in order to show the structures more clearly, a region between the upper pressurizing member 121 and the lower pressurizing member 122 is shown with a larger spacing than the actual spacing. In addition, in FIG. 8, in order to show the structures more clearly, illustration of sheet rolls 125, 126, 128, and 129 which will be described later is omitted.

The upper pressurizing member 121 includes a heater built therein, and includes a mechanism which moves upward and downward. The upper pressurizing member 121 is pressurized with a predetermined pressure, so that the wiring member 21 is pressed against the solar cell 20. Then, the upper pressurizing member 121 is heated to a temperature greater than or equal to the curing temperature of the adhesive 22, so that the adhesive 22 is completely cured, and the solar cell 20 and the wiring member 21 are adhered to each other.

A pressure when the wiring member 21 is pressed against the solar cell 20 using the upper pressurizing member 121 is, for example, greater than or equal to 2000 Pa and less than or equal to 50000 Pa. Further, a temperature of the upper pressurizing member 121 during the pressurization is, for example, greater than or equal to 150°C and lower than or equal to 260°C.

Similar to the upper pressurizing member 121, the lower pressurizing member 122 may include a mechanism which moves upward and downward. The lower pressurizing member 122 may include a heater built therein, but in the present embodiment, the lower pressurizing member 122 does not include a built-in heater. When a heater is built into the lower pressurizing member 122, a temperature of the lower pressurizing member 122 during the pressurization is desirably lower than the temperature of the upper pressurizing member 121 during the pressurization.

Moreover, in the present embodiment, each of the upper pressurizing member 121 and the lower pressurizing member 122 is formed from one member, but alternatively, each of these members may be formed from a plurality of members. For example, each of the upper pressurizing member 121 and the lower pressurizing member 122 may be formed from the same number of members as the number of solar cells 20 forming the provisionally fixed assembly 30.

The upper sheet placement mechanism 123 is a mechanism which places a first sheet member 140 having a suitable slipperiness between the upper pressurizing member 121 and the first surface of the solar cell 20. The upper sheet placement mechanism 123 includes two sheet rolls 125 and 126. The two sheet rolls 125 and 126 repeat winding of the first sheet member 140 while placing the first sheet member 140 in a manner to cover the upper pressurizing member 121.

Desirably, a mechanism which removes contamination attached to the surface of the first sheet member 140 is provided on the upper sheet placement mechanism 123. In the present embodiment, a brush 127 is provided at an outer side of the sheet roll 126. With this configuration, when the first sheet member 140 is wound by the sheet roll 126, the brush 127 contacts the surface of the first sheet member 140, and the contamination on the surface of the first sheet member 140 is removed.

The lower sheet placement mechanism 124 is a mechanism which places the first sheet member 140 having suitable slipperiness between the lower pressurizing member 122 and the second surface of the solar cell 20. The lower sheet placement mechanism 124 includes two sheet rolls 128 and 129. The two sheet rolls 128 and 129 repeat winding of the first sheet member 140 while placing the first sheet member 140 in a manner to cover the lower pressurizing member 122.

Similar to the upper sheet placement mechanism 123, desirably, a mechanism which removes the contamination attached to the surface of the first sheet member 140 is provided on the lower sheet placement mechanism 124. In the present embodiment, a brush 130 for removing contamination on the surface of the first sheet member 140 is provided at an outer side of the sheet roll 129. With this configuration, when the first sheet member 140 is wound by the sheet roll 129, the brush 130 contacts the surface of the first sheet member 140, and the contamination on the surface of the first sheet member 140 is removed.

Here, a coefficient of kinetic friction of the first sheet member 140 is lower than or equal to 0.3, and the hardness of the first sheet member 140 is greater than or equal to D40. When the pressure-bonding is performed in a state where the provisionally fixed assembly 30 is sandwiched with the first sheet members 140 above and below the provisionally fixed assembly 30, the first sheet member 140 and the wiring member 21 suitably slip during the pressurization, and elongation of the wiring member 21 can be reduced. With this configuration, stress from the wiring member 21 to the solar cell 20 can be reduced, and occurrence of cracks of the solar cell 20 can be suppressed. The coefficient of kinetic friction described above is a value measured according to a method described in the standard, JIS K7125:1999, "Plastic -film and sheet- frictional coefficient testing method". In addition, the hardness described above is a value measured using a type-D durometer according to a method described in the standard, JIS K6253-3:2012.

The coefficient of kinetic friction of the first sheet member 140 is desirably lower than or equal to 0.25, is more desirably lower than or equal to 0.2, and is further desirably lower than or equal to 0.15. In this case, the elongation of the wiring member 21 during the pressure-bonding can be reduced, and the occurrence of the cracks of the solar cell 20 can be further suppressed. In addition, the hardness of the first sheet member 140 is desirably greater than or equal to D45, and is more desirably greater than or equal to D50.

A coefficient of thermal expansion of the first sheet member 140 is desirably lower than or equal to 5×10⁻⁵/K, is more desirably lower than or equal to 4×10⁻⁵/K, and is further desirably lower than or equal to 3×10⁻⁵/K. In this case, the elongation of the wiring member 21 during the pressure-bonding can be further reduced, and the occurrence of the cracks of the solar cell 20 can be further suppressed.

As the first sheet member 140, for example, glass cloth coated with a fluororesin may be exemplified. As the fluororesin, for example, there may be exemplified polytetrafluoroethylene (PTFE), a copolymer of tetrafluoroethylene-hexafluoropropylene (FEP), and a copolymer of tetrafluoroethylene-fluoroalkylvinyl ether (PFA).

A thickness of the first sheet member 140 is desirably greater than or equal to 0.05 mm and less than or equal to 2.0 mm, and is more desirably greater than or equal to 0.1 mm and less than or equal to 1.0 mm. In this case, the elongation of the wiring member 21 during the pressure-bonding can be further reduced, and the occurrence of the cracks of the solar cell 20 can be further suppressed.

As shown in FIGs. 7 and 8, a second sheet member 150 having a cushioning property is placed between the lower sheet placement mechanism 124 and the lower pressurizing member 122. When the second sheet member 150 is placed, the second sheet member 150 compensates for the influence of unevenness of the solar cell 20 and the wiring member 21. With this configuration, the pressure during the pressurization can be made more uniform, and the misalignment of the wiring member 21 and the cracks of the solar cell 20 can be suppressed. A hardness of the second sheet member 150 is desirably less than D40, is more desirably less than or equal to D35, and is further desirably less than or equal to D30. No particular limitation is imposed on a coefficient of thermal expansion of the second sheet member 150, and, for example, the coefficient of thermal expansion of the second sheet member 150 may be larger than the coefficient of thermal expansion of the first sheet member 140.

As the second sheet member 150, for example, a silicone sheet or a silicone sponge may be exemplified.

A thickness of the second sheet member 150 is desirably greater than or equal to 0.01 mm and less than or equal to 20 mm, and is more desirable greater than or equal to 0.1 mm and less than or equal to 10 mm. In this case, the pressure during the pressurization can be made more uniform, and the suppression advantages of the misalignment of the wiring member 21 and the cracks of the solar cell 20 are more significant.

In the present embodiment, the second sheet member 150 is placed in the lower sheet placement mechanism 124, between the first sheet member 140 and the lower pressurizing member 122, but alternatively, the second sheet member 150 may be included in the lower sheet placement mechanism 124. That is, the lower sheet placement mechanism 124 may be a mechanism which places a sheet member, in which the first sheet member 140 and the second sheet member 150 are layered, between the lower pressurizing member 122 and the second surface of the solar cell 20. When the second sheet member 150 is included in the lower sheet placement mechanism 124, a gap is caused between the second sheet member 150 and the lower pressurizing member 122. With this configuration, it is possible to limit the time of contact between the second sheet member 150 and the lower pressurizing member 122 solely to the time of pressurization, and degradation of the second sheet member 150 due to heat can be suppressed. Alternatively, another sheet placement mechanism may be provided between the lower sheet placement mechanism 124 and the lower pressurizing member 122, and the second sheet member 150 may be placed between the lower sheet placement mechanism 124 and the lower pressurizing member 122 using this sheet placement mechanism. In this case, a gap is caused between the second sheet member 150, and the first sheet member 140 and the lower pressurizing member 122.

The pressure-bonding apparatus 120 desirably includes a mechanism which prevents sticking between the first sheet member 140 and the solar cell string 10 (refer to FIG. 1) after the pressure bonding. As the mechanism for preventing the sticking, for example, a function for temporarily loosening the first sheet member 140 may be provided on the upper sheet placement mechanism 123 or the lower sheet placement mechanism 124. Alternatively, for example, a pin which can move upward and downward, and which pushes the first sheet member 140 upward after the pressure bonding may be provided on the upper sheet placement mechanism 123 or the lower sheet placement mechanism 124.

Further, the pressure-bonding apparatus 120 may include a mechanism which detects positions of the provisionally fixed assembly 30 and the solar cell string 10 before and after the pressure bonding. With this structure, an amount of misalignment before and after the pressure bonding can be identified. As a method of detecting the positions of the provisionally fixed assembly 30 and the solar cell string 10, there may be exemplified, for example, a method of detecting, using an optical sensor, a position of an alignment mark provided on the provisionally fixed assembly 30 and the solar cell string 10. Further, the pressure-bonding apparatus 120 may include a mechanism which adjusts a position of the solar cell string 10 after the pressure bonding, and may include a mechanism which moves, using an arm or the like, the solar cell string 10 in a direction that is different to the longitudinal direction of the solar cell string 10. Moreover, the lower sheet placement mechanism 124 may include a transport function of the solar cell string 10.

The solar cell module 1 can be manufactured by laminating the solar cell string 10, produced through the manufacturing method of the solar cell string 10 described above, and using resin sheets forming the first protective member 11, the second protective member 12, and the sealing layer 13. In a laminating apparatus, a first resin sheet which forms the first protective member 11 and the sealing layer 13, a second resin sheet which forms the solar cell string 10 and the sealing layer 13, and the second protective member 12 are layered in this order over a heater. This layered assembly is heated, for example, to a temperature at which the resin sheet forming the sealing layer 13 is softened in a vacuum state. Then, the heating is continued while pressing the constituting members toward the heater side under atmospheric pressure, to laminate the members, and the solar cell module 1 is finally obtained.

As described, the method of manufacturing the solar cell string 10 according to the present embodiment includes the solar cell preparation step S1, the adhesive application step S2, the provisional fixation step S3, the transport step S4, and the pressure-bonding step S5. The provisional fixation step S3 is a step in which the current collector electrode of the solar cell 20 and the wiring member 21 are provisionally fixed to each other with the adhesive 22 therebetween, without heating. The transport step S4 is a step in which, after the provisional fixation step S3, while a state where the wiring member 21 and the current collector electrode are provisionally fixed to each other by the stickiness of the adhesive 22 is maintained, the assembly is moved to the pressure-bonding apparatus 120 while not pressurizing or heating the wiring member 21. The pressure-bonding step S5 is a step in which the adhesive 22 is heated by the pressure-bonding apparatus 120 to a temperature greater than or equal to the curing temperature of the adhesive 22, to cure the adhesive 22, and to thereby adhere the current collector electrode of the solar cell 20 and the wiring member 21 to each other.

As described, in the manufacturing method of the solar cell string 10 according to the present embodiment, in the provisional fixation step S3 and the transport step S4, no heating process is applied, and processes are performed while maintaining the provisionally fixed state of the wiring member 21 and the current collector electrode by the stickiness of the adhesive 22. Because of this, scattering of the resin or the like forming the adhesive 22 does not occur, and contamination of the manufacturing apparatus of the solar cell string 10 can be suppressed. In addition, because no additional heating step is necessary, the manufacturing cost can be reduced.

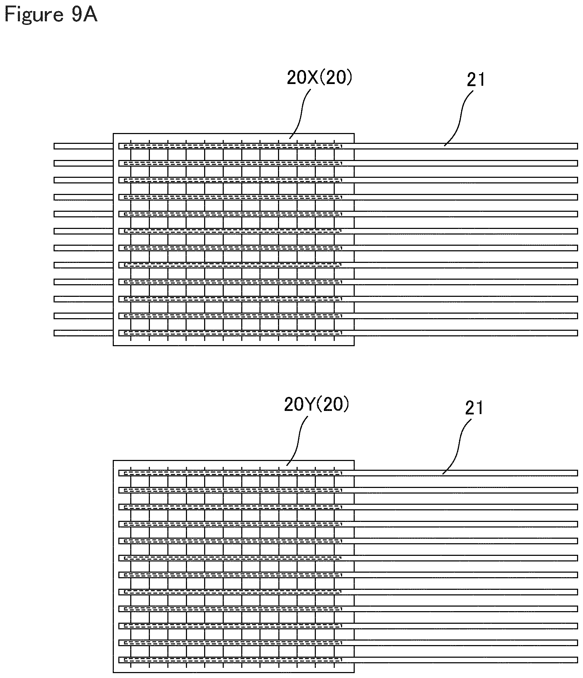

A solar cell module 1 according to a second embodiment of the present disclosure will now be described with reference to FIGs. 9A to 9C. FIGs. 9A to 9C are diagrams showing the provisional fixation step S3, and are plan views of the solar cell 20, viewed from the first surface side. In the first embodiment, in the provisional fixation step S3, the provisionally fixed assembly 30 is produced by sequentially placing the solar cells 20, on the first surface and the second surface of which the adhesive 22 is applied. On the other hand, in the second embodiment, the provisionally fixed assembly 30 is produced by sequentially placing solar cells 20, on the first surface and the second surface of which the adhesive 22 is applied, and on at least the first surface of which the wiring member 21 is provisionally fixed. The details of the solar cell module 1 according to the second embodiment will now be described.

As shown in FIG. 9A, first, a solar cell 20X is produced, on the first surface and the second surface of which the adhesive 22 is applied, and on the first surface and the second surface of which the wiring member 21 is provisionally fixed with the adhesive 22 therebetween. The solar cell 20X may be produced through a manufacturing method similar to that in the first embodiment. In addition, as shown in FIG. 9A, a solar cell 20Y is produced, on the first surface and the second surface of which the adhesive 22 is applied, and on only the first surface of which the wiring member 21 is provisionally fixed with the adhesive 22 therebetween. The solar cell 20Y may be produced, for example, by producing the provisionally fixed assembly 30 through the steps of FIGs. 4A to 4C described above with reference to the first embodiment, and flipping the provisionally fixed assembly 30 while holding the solar cells 20X and 20Y and the wiring member 21. In this process, a direction perpendicular to the length direction of the wiring member 21 and parallel to a long side of the solar cells 20X and 20Y is set as a rotational axis, and a desirable direction is a direction in which the force of inertia and the centrifugal force presses the wiring member 21 toward the cell side. The assembly may be flipped while supporting a part of the wiring member 21. In addition, the solar cell 20Y may be produced by, for example, placing the solar cell 20Y on a stage on which a gap is provided at a position of the adhesive 22 applied on the side of the second surface of the solar cell 20Y, and through the steps shown in FIGs. 4D and 4E described above with reference to the first embodiment.

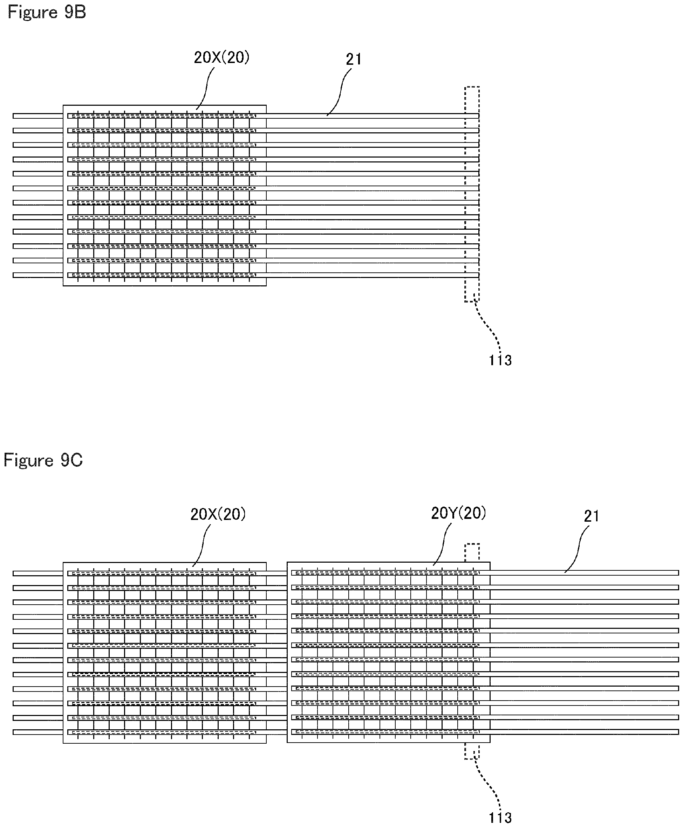

Next, as shown in FIG. 9B, the solar cell 20X is placed on the stage (not shown). With the wiring member fixer 113, a portion, of the wiring member 21 provisionally fixed on the first surface side of the solar cell 20X, of a region which is not provisionally fixed with the solar cell 20X, is fixed on the stage. In this process, similar to the first embodiment, the wiring member 21 may be adjusted so that the wiring member 21 is placed at an appropriate position.

Next, as shown in FIG. 9C, the solar cell 20Y is placed over a region, of the wiring member 21 provisionally fixed to the solar cell 20X, which is not provisionally fixed to the solar cell 20X. In this process, the solar cell 20Y is placed in such a manner that the adhesive 22 applied over the second surface of the solar cell 20Y overlaps the wiring member 21 fixed on the stage. With this configuration, the current collector electrode formed over the second surface of the solar cell 20Y, and the wiring member 21, are provisionally fixed to each other with the adhesive 22 therebetween. Alternatively, similar to the case shown in FIG. 6 and described above, after the solar cell 20Y is placed, the wiring member 21 may be adjusted so that the wiring member 21 is placed at an appropriate position.

After the current collector electrode formed over the second surface of the solar cell 20Y, and the wiring member 21, are provisionally fixed to each other, the stage is moved to the left of FIG. 9C so that the solar cell 20Y is positioned at the position of the solar cell 20X before the movement. In this process, the position of the wiring member 21 may be adjusted in correspondence with the movement of the stage. The steps shown in FIGs. 9B and 9C and described above are repeated a predetermined number of times, so that the provisionally fixed assembly 30 can be produced in which a plurality of the solar cells 20 are provisionally fixed.

In the second embodiment, a structure may be used in which the front and back side positional relationship of the solar cells 20X and 20Y and the wiring member 21 is reversed. In this case, the solar cells 20X and 20Y can be produced through the steps of FIGs. 4A to 4D, but in the production process of the provisionally fixed assembly 30, additional steps are necessary to pull the wiring member 21 placed over the solar cell 20X upward, which is in the reversed front and back relationship from the case of FIGs. 4A to 4D, and to pull upward and move the solar cell 20Y in the reversed front and back positional relationship from that of FIGs. 4A to 4D. For the pulling upward of only the wiring member 21, a scheme identical to that of the wiring member drawer 112 and the wiring member fixer 113 may be used, or a mechanism may be used which slides a flat-plate shape object having a high slipperiness below the wiring member 21, to pull the wiring member 21 upward. For the step of pulling upward and moving the solar cell 20Y and the wiring member 21 in the reversed front and back positional relationship, a mechanism may be used which slides a flat-plate shape object having a high slipperiness below the wiring member 21, to pull the wiring member 21 upward, or a feed mechanism may be used which pulls a workpiece or the like upward and moves the workpiece or the like a certain distance.

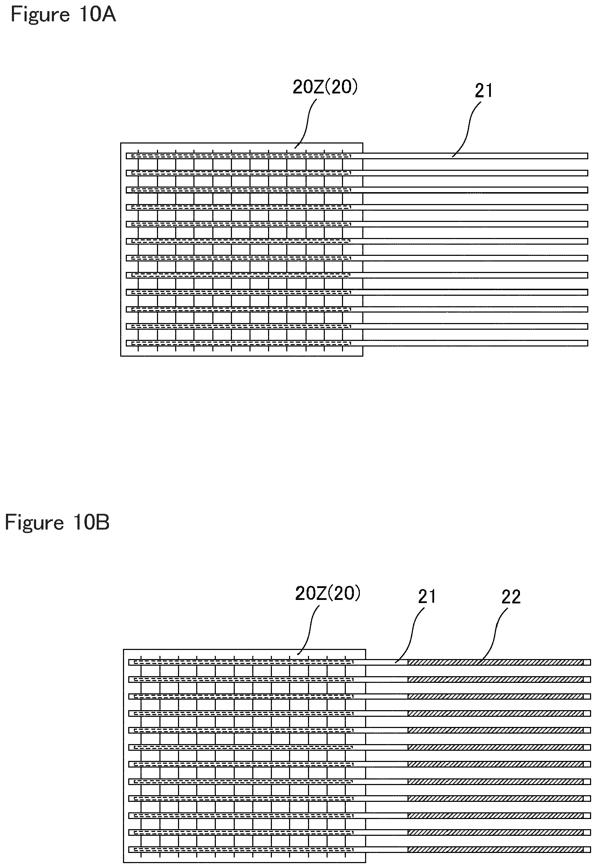

Next, a solar cell module 1 according to a third embodiment of the present disclosure will be described with reference to FIGs. 10A to 10C. FIGs. 10A to 10C are diagrams showing the provisional fixation step S3, and are plan views of the solar cell 20, viewed from the first surface side. In the third embodiment, in the adhesive application step S2, the adhesive 22 is applied only on the first surface side of the solar cell 20. That is, the solar cell module 1 of the third embodiment differs from the solar cell modules 1 of the first and second embodiments in that the adhesive 22 is not applied on the second surface side of the solar cell 20 in the adhesive application step S2.

As shown in FIG. 10A, a solar cell 20Z is produced in which the adhesive 22 is applied only over the first surface and the wiring member 21 is provisionally fixed only over the first surface with the adhesive 22 therebetween. The solar cell 20Z can be produced through a manufacturing method similar to that of the first embodiment.

Next, as shown in FIG. 10B, the solar cell 20Z is placed on a stage (not shown). The adhesive 22 is applied over a portion, of the wiring member 21 provisionally fixed to the solar cell 20Z, of a region which is not provisionally fixed to the solar cell 20Z. As a method of applying the adhesive 22, there may be exemplified dispensing, transferring using a sheet, and printing using a roller or a brush. In FIG. 10B, a region over which the adhesive 22 is applied is shown with hatching.

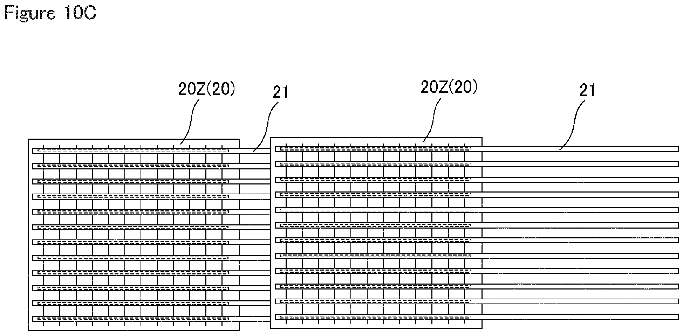

Then, as shown in FIG. 10C, another solar cell 20Z is placed over a region, of the wiring member 21 provisionally fixed on the first surface side of the solar cell 20Z, which is not provisionally fixed to the solar cell 20Z and over which the adhesive 22 is applied. With this process, the current collector electrode formed over the second surface of the solar cell 20Z, and the wiring member 21, are provisionally fixed to each other with the adhesive 22 therebetween. While the stage is moved to the left of FIG. 10C, the steps shown in FIGs. 10B and 10C and described above are repeated a predetermined number of times, so that a provisionally fixed assembly 30 is produced in which a plurality of the solar cells 20 are provisionally fixed. In this process, the wiring member 21 may be fixed on the stage during application of the adhesive 22. In addition, the position of the wiring member 21 may be adjusted after the adhesive 22 is applied or after the other solar cell 20Z is placed.

The present disclosure is not limited to the embodiments described above, and various modifications and improvements are possible within the scope and spirit of the present disclosure described in the claims.

While the foregoing has described what are considered to be the best mode and/or other examples, it is understood that various modifications may be made therein, and that the subject matter disclosed herein may be implemented in various forms and examples, and that they may be applied in numerous applications, only some of which have been described herein. It is intended by the following claims to claim any and all modifications and variations that fall within the true scope of the present teachings.

## Claims

1. A method of manufacturing a solar cell string (10) comprising:
solar cells (20) including a first solar battery (20) cell having a first surface and a second surface which face in opposite directions to each other, and a second solar cell (20) having a first surface and a second surface which face in opposite directions to each other, and placed adjacent to the first solar cell; and
a wiring member (21) connecting the first surface of the first solar cell (20) and the second surface of the second solar cell (20), the method comprising:
a provisional fixation step in which, at a first position and at a temperature lower than or equal to 50°C, the wiring member (21) is placed over the solar cell (20) with an adhesive (22) therebetween, and the wiring member (21) and the solar cell (20) are provisionally fixed to each other;
a transport step in which, after the provisional fixation step, the wiring member (21) and the solar cell (20) are moved to a second position while a state in which the wiring member (21) and the solar cell (20) are provisionally fixed to each other by stickiness of the adhesive (22) is maintained; and
a pressure-bonding step in which, at the second position, the adhesive (22) is heated to a temperature greater than or equal to a curing temperature of the adhesive (22) while the wiring member (21) is pressurized, to cure the adhesive (22), wherein
a viscosity of the adhesive (22) before being cured at a temperature of 30°C and a shearing velocity of 0.01/sec. is greater than or equal to 50 Pa·s.

2. The method of manufacturing the solar cell string (10) according to claim 1, wherein
after the provisional fixation step, the transport step is performed while maintaining the temperature lower than or equal to 50°C, and then, the pressure-bonding step is performed.

3. The method of manufacturing the solar cell string (10) according to claim 1 or 2, wherein
in the provisional fixation step, the wiring member (21) is placed over the solar cell (20) after a tension force in a length direction of the wiring member (21) is applied to the wiring member (21), to straighten curvature of the wiring member (21).

4. The method of manufacturing the solar cell string (10) according to any one of claims 1 to 3, wherein
in the provisional fixation step, the wiring member (21) is placed over the solar cell (20) while a tension force in a length direction of the wiring member (21) is applied to the wiring member (21).

5. The method of manufacturing the solar cell string (10) according to any one of claims 1 to 4, wherein
in the provisional fixation step, the wiring member (21) is placed over the solar cell (20) with the adhesive (22) therebetween, and a pressure of greater than or equal to 10 Pa is applied, so that the wiring member (21) and the solar cell (20) are provisionally fixed to each other.

6. The method of manufacturing the solar cell string (10) according to any one of claims 1 to 5, wherein
in the transport step, after the provisional fixation step, the wiring member (21) and the solar cell (20) are moved to the second position while a state in which the wiring member (21) and the solar cell (20) are provisionally fixed to each other by stickiness of the adhesive (22) is maintained, without pressurizing the wiring member (21).

7. The method of manufacturing the solar cell string (10) according to any one of claims 1 to 6, wherein
in the transport step, after the provisional fixation step, the wiring member (21) and the solar cell (20) are moved only in a length direction of the wiring member (21) while a state in which the wiring member (21) and the solar cell (20) are provisionally fixed to each other by stickiness of the adhesive (22) is maintained.

8. The method of manufacturing the solar cell string (10) according to any one of claims 1 to 7, wherein
in the pressure-bonding step, a plurality of the solar cells (20) are thermally pressure-bonded, to cure the adhesive (22).
